# EUROPEAN PATENT APPLICATION

(11) **EP 4 545 921 A1**
(43) Date of publication of application: **30.04.2025**
(21) Application number: 23205507.9
(22) Date of filing: 24.10.2023
(51) Int. Cl.: G01J 3/10

(54) **THERMAL EMITTER, METHOD FOR OPERATING A THERMAL EMITTER AND MEMS GAS/FLUID SENSOR**

(71) Applicant: Infineon Technologies AG, 85579 Neubiberg (DE)
(72) Inventor: MITTEREDER, Tobias, 81369 München (DE); GHADERI, Mohammadamir, 93047 Regensburg (DE)
(74) Representative: Hersina, Günter

(57) **Abstract**

A method for operating a thermal emitter having an electrically conductive semiconductor section, comprises - providing, during an operational cycle, an activation signal having a first energy level (Joule heating) to the electrically conductive semiconductor section of the thermal emitter for emitting an IR radiation, and - providing, during a refresh cycle, a refresh signal having a second energy level to the electrically conductive semiconductor section of the thermal emitter, wherein the second energy level is different to the first energy level.

## Description

### Technical Field

Embodiments of the present disclosure relate to a thermal emitter (Joule heater), a method for operating the thermal emitter having an electrically conductive semiconductor section (Joule heater structure), and to a MEMS fluid (gas or liquid) sensor using the thermal emitter. The present disclosure further relates to improving the (long-term) operational stability of a thermal emitter by applying a refresh signal during a refresh cycle to the thermal emitter.

### Background

The sensing of environmental parameters in the ambient atmosphere, such as noise, sound, temperature and gases, e.g. environmental gas components, gains more and more importance in the implementation of appropriate sensors within mobile devices, home automation, such as smart home, and the automotive sector. Harmful gas concentrations can occur due to pollution and/or a malfunction of a device. However, the well-being of a person or animal is strongly influenced by the air quality. Thus, the exact and reliable gas detection in the environmental atmosphere by inexpensive, always available and accurate sensors is an upcoming topic in the future.

In the field of monitoring the air quality in our environment, there are several types of gas sensing concepts, for example, the non-dispersive infrared (NDIR) sensors, chemical sensors and photo-acoustical sensors (PAS = photoacoustic spectroscopy). A sensor effect often used bases on the excitation of gas molecules in a medium by (infrared) light with a certain wavelength. However, currently available NDIR or PAS systems are relatively expensive due to their complex setups or special components. Further, chemical sensors show a relatively poor selectivity compared to single-wavelength or filter containing optical systems. A typical optical sensor, e.g. a PAS sensor, comprises a radiation source, filter elements for a wavelength selection, a detector and the sample area where the light between the light source and the detector interacts with the environmental medium.

With the evermore extensive use of gas sensors, there is a particular need to be able to operate such gas sensors having thermal emitters (MEMS heaters) as accurately and, also, as inexpensively as possible over the lifetime of the gas sensor.

Such a need can be solved by the method for operating a thermal emitter according to claim 1, the thermal emitter according to claim 10 and the MEMS gas or fluid sensor according to claim 15.

Further specific implementations of the present concept for operating a thermal emitter are defined in the dependent claims.

Accordingly, the present disclosure describes a method for operating a thermal emitter which, for example, may be part of a MEMS gas or fluid sensor that is able to sense at least one component of the environmental atmosphere, wherein the long-term stability of the emission characteristics of the MEMS heater is improved by including refresh cycles to or between measurement cycles of the sensor. The thermal emitter for infrared or mid-infrared radiation can be used in any MEMS device having an IR radiation source.

### Summary

According to an embodiment, a method for operating a thermal emitter having an electrically conductive semiconductor section, comprises - providing, during an operational cycle, an activation signal having a first energy level (Joule heating) to the electrically conductive semiconductor section of the thermal emitter for emitting an IR radiation, and - providing, during a refresh cycle, a refresh signal having a second energy level to the electrically conductive semiconductor section of the thermal emitter, wherein the second energy level is different to the first energy level.

According to an embodiment, a thermal emitter comprises - a heater element having an electrically conductive semiconductor section, and - a driver element (e.g. an ASIC or a microcontroller) for providing, during an operational cycle, an activation signal having a first energy level to the electrically conductive semiconductor section of the thermal emitter for emitting an IR radiation, and for providing, during a refresh cycle, a refresh signal having a second energy level to the electrically conductive semiconductor section of the thermal emitter, wherein the second energy level is different to the first energy level.

According to an embodiment, a MEMS gas or fluid sensor comprises - the (above) thermal emitter for emitting thermal radiation, - a measurement volume having a target gas or target fluid and providing an optical interaction path for the emitted thermal radiation, and - an acoustic transducer or a direct thermal detector for providing a detector output signal based on the optical interaction of the emitted thermal radiation with the target gas or target fluid in the measurement volume.

Further embodiments are described in the dependent claims.

### Brief Description of the Figures

In the following, embodiments of the present disclosure are described in the following in more detail while making reference to the accompanying drawings, in which:
- Fig. 1: shows a schematic flow chart of a method for operating a thermal emitter (MEMS heater) according to an embodiment;
- Figs. 2a-b: show schematic block diagrams of an emitter excitation with a refresh cycle according to an embodiment;
- Fig. 3: shows a schematic illustration of the "hot" drift behavior of a MEMS emitter over lifetime (with a refresh operation);
- Fig. 4: shows a schematic block diagram of a thermal emitter device (Joule heater device) according to an embodiment;
- Fig. 5: shows a schematic block diagram of a fluid sensor using the thermal emitter (MEMS heater) according to an embodiment;
- Fig. 6: shows a schematic block diagram of a PAS gas (fluid) sensor according to an embodiment;
- Fig. 7: shows a schematic block diagram of an NDIR gas (fluid) sensor according to an embodiment;.
- Fig. 8a-b: show a schematic top (plane) view and a schematic cross-sectional view of a thermal emitter; and
- Fig. 9: shows a schematic illustration of the "hot" drift behavior of a thermal (MEMS) emitter over lifetime (without a refresh operation).

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed description of illustrative embodiments

In the following description, embodiments are discussed in detail, however, it should be appreciated that the embodiments provide many applicable concepts that can be embodied in a wide variety of a thermal emitter. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled it the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, the figures comprise a Cartesian coordinate system x, y, z, wherein the x-y-plane corresponds, i.e. is parallel, to a first main surface region of a substrate (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction, i.e. parallel to the x-y-plane, wherein the term "vertical" means a direction parallel to the z-direction.

In the following description, a thickness of an element usually indicates a vertical dimension of such an element. In the figures, the different elements are not necessarily drawn to scale. Thus, the illustrated dimensions of the different elements may not be necessarily drawn to scale.

In the description of the embodiments, terms and text passages placed in brackets (next to a described element or function) are to be understood as further explanations, exemplary configurations, exemplary additions and/or exemplary alternatives of the described element or function.

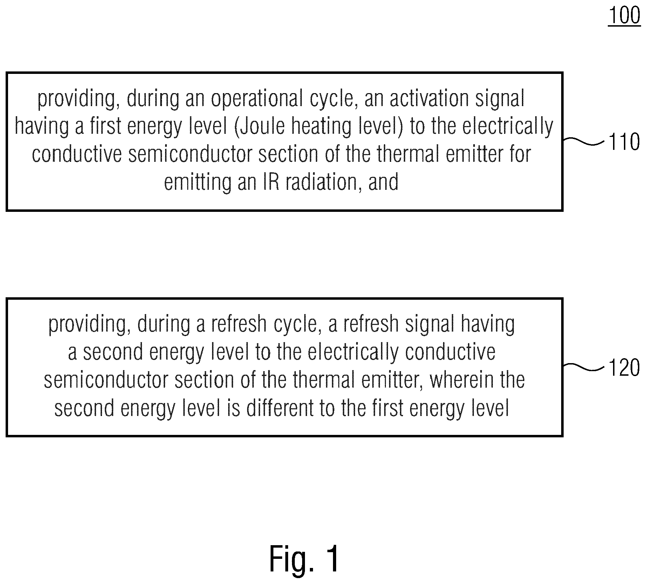

Embodiments of the present disclosure relate to an improved operation of a thermal heater (Joule heater or MEMS emitter), wherein a refresh signal is applied during a refresh cycle (mode) to the thermal emitter to improve the (long-term) operational stability of a thermal emitter, as described with respect to Figs. 1 to 7. Thus, an increased sensing accuracy of a fluid (gas or liquid) sensor using such a MEMS heater over its lifetime can achieved.

However, before describing different embodiments of the present disclosure, the findings and observations of the inventors of the present disclosure with respect to the physical characteristics and the long time behavior of Joule heater structures and the resulting technical impacts to gas sensors (e.g. long term effects or drifts over the sensor lifetime) are summarized.

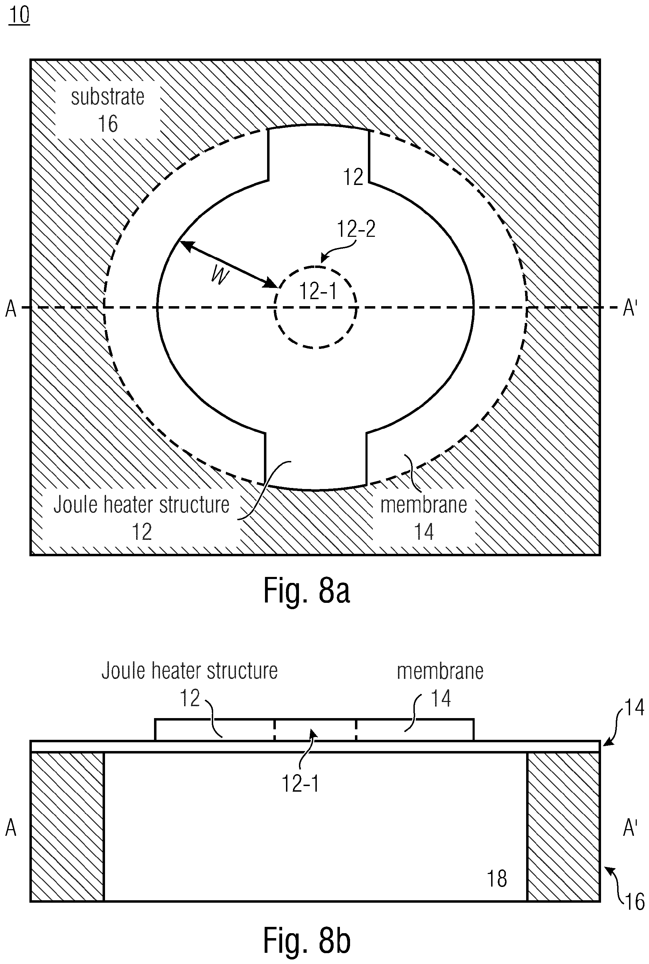

Fig. 8a shows a schematic top view (parallel to the x-y-plane) and Fig. 8b shows a schematic cross-sectional view (parallel to the x-z-plane) along a sectional line AA' of an exemplary thermal emitter 10 (MEMS heater = Joule heater). The operating principle of a MEMS heater is usually called "Joule heating" and also known as resistive, resistance, or Ohmic heating. The Joule heating of the MEMS heater is the process by which the passage of an electric current (in response to an applied drive signal, e.g. a voltage) through an electrical conductor of the MEMS heater produces heat.

As exemplarily shown in Figs. 8a-b, the thermal emitter 10 comprises a Joule emitter structure 12 e.g. in form of an electrically conductive semiconductor section, which may comprise a doped poly-Si material. The thermal emitter 10 may comprise a membrane 14 supported by a substrate 16 (e.g. a bulk Si substrate) wherein the membrane 14 comprises the electrically conductive section 12 (Joule heater section), e.g. the electrically conductive semiconductor material. As shown in Figs. 8a-b, the Joule emitter structure 12 may be arranged on the membrane 14 (e.g. comprising an insulating material, such as SiN, and/or a Si material, such as poly Si). Alternatively, the Joule emitter structure 12 may be part of the membrane 14, e.g. a highly doped poly-Si region 12 of a poly-Si membrane 14.

The Joule heater structure 12 may be arranged on a cavity 18 in the substrate 16. The substrate 16 may comprise a bulk semiconductor substrate (e.g. a bulk Si substrate). Based on the construction of the Joule heater structure 12, such a radiation source 10, e.g. for a gas or fluid sensor, can provide a relatively high thermal resistance (= low thermal mass) for achieving a relatively high energy efficiency (= high temperature increase per watt input power), wherein the thermal emitter can be operated at relatively high operating temperatures (e.g. at 600 °C or higher) due to this setup.

According to an embodiment, the electrically conductive section 12 may optionally form a branched current path separated by the center section 12-1. As exemplarily shown in Fig. 8a, the electrically conductive section 12 may form a ring-shaped heating element having width W, that produces during an activated state (= electrical energization of the electrically conductive section 12) heat that may also spread into/through the (optional) center section 12-1.

The, center section 12-1 may comprise a low doped or undoped semiconductor (e.g. poly Si) material so that the electrically conductive section 12 forms the branched current path separated by the center section 12-1. Further, both regions 12, 12-1 may have the same layer thickness. Thus, the center section 12-1 and the electrically conductive section 12 may together form a resulting heating structure or heating element for emitting or dissipating heat in form of thermal (e.g. infrared) radiation, e.g. into a measurement cavity. Thus, the heated ring-shaped electrically conductive section 12 may provide for a relatively uniform temperature profile in the heating structure.

According to a further embodiment, the center section (center region) 12-1 may also comprise a similarly doped material as the heater (the electrically conductive section) 12 but separated by a narrow segmentation (segmentation line) 12-2, that provides electrical isolation between the center section 12-1 and the electrically conductive section 12, but maintains a sufficient thermal conductance to the electrically conductive section (the heater) 12.

According to a further embodiment, the center section (center region) 12-1 may also comprise a insulating material (e.g. SiN) having a similar (within a range of ±5% or ±2% the same) thermal expansion coefficient as the material of the heater (the electrically conductive section) 12 and maintaining a sufficient thermal conductance to the electrically conductive section (the heater) 12.

According to a further embodiment, the electrically conductive section 12 may also comprise one of a circle, square, oval and ellipse shape (or any convex polygon shape), wherein this list of shapes of the electrically conductive section 12 is not to be regarded as exhaustive.

The (set) conductor width W (see Fig. 8a) of the electrically conductive section 12 may depend on the driving voltage for which the Joule heater structure 12 of the MEMS heater 10 is designed. The conductor width W (and the resulting footprint of the heater 12) is usually larger for lower driving voltages, wherein the temperature non-uniformity of the Joule heater structure 12 is also usually larger for lower driving voltages.

Generally, a MEMS joule heater requires to reach temperatures above 600°C to generate sufficient optical output power required for the gas sensing during a gas measurement operation. For a voltage driven heater, the resistance of the heater has to be reduced in order to decrease the required driving voltage. The geometry optimization of a low voltage emitter favors distributed planner heater designs, i.e. with wider footprint, which due to varying proximities to the membrane boundaries, result in (relatively) large temperature variation over the electrically active heater (= clamping loss). An increase in poly-Si layer thickness has a similar effect as the conductive heat loss via the poly-Si heater also increases.

The inventors of the present disclosure have further recognized the following physical relationships: The high temperature variation, i.e. the non-uniformity, at temperatures above the dopant activation energy (~600°C) in poly-Si changes the local dopant distribution over time. To be more specific, the broader or larger the Joule heater structure (Joule wire) 12 (e.g. the sum of R squares * membrane thickness) the faster is the degradation of the resistor structure 12, i.e. the change of the material properties (characteristics) of the Joule heater structure 12), and, thus, the drift of the electrical characteristics.

The inventors of the present disclosure have recognized that, under the describes operational conditions of the thermal heater 10 (MEMS emitter or Joule heater), a systematic (up)drift of the electrical resistance of the thermal emitter can be observed.

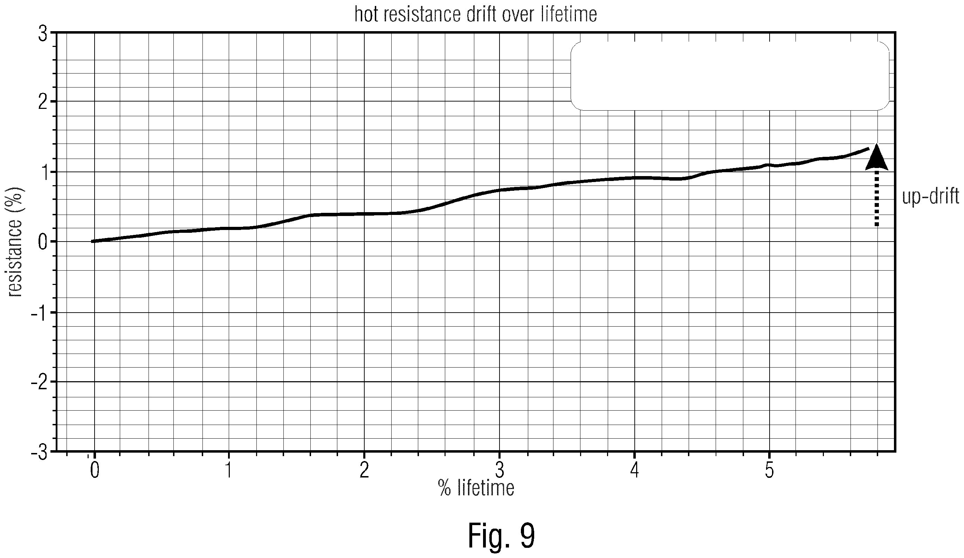

Fig. 9 shows a schematic illustration of the "hot" drift behavior of a MEMS emitter over lifetime (without a refresh operation). For example, the systematic (up)drift of the electrical resistance of the Joule emitter structure 12 may arise due to the temperature non-uniformity over the width W of the Joule heater structure 12. Due to this (up)drift of the electrical resistance of the emitter 12, the emitter 12 consumes less electrical power and emits less light (IR radiation) at a given voltage (driving signal). The gas measurement reading on a calibrated sensor with such an emitter is therefore detuned. As consequence, the PPM accuracy (PPM = parts per million) or detection accuracy of the gas sensor using the emitter 10 is decreasing over lifetime. In other words, as the resistance of the heater varies over sensor lifetime, the optical output power of the emitter varies resulting in deviation from target specification, so that the long term performance of the sensor using the emitter is adversely affected.

The inventors of the present disclosure have recognized that the physics behind this behavior can be explained as follows. When applying a voltage on a MEMS Joule heater, different local temperatures on the Joule heater itself are reached. This non-uniformity is due to different thermal insulation of respective areas on the MEMS Joule heater, i.e. by consequence by the emitter design. For a semiconductor material, e.g. poly-silicon (Poly-Si) or silicon carbide (SiC) as conducting material, different local temperatures above the activation energy for dopant diffusion (around 600 °C) lead to a locally different electrical drift behavior of the thermal emitter (MEMS Joule heater). This effect/behavior is called as temperature-dependent "dopant segregation". The conductivity of poly crystalline silicon is changed (i.e. decreased) by the segregation of dopant atoms to the grain boundaries, where the atoms themselves are trapped and become electrically inactive. This effect (temperature-dependent dopant segregation) increases with the temperature non-uniformity over the width of the Joule heater structure.

Fig. 1 shows a schematic flow chart of a method 100 for operating a thermal emitter 10 (MEMS heater) having an electrically conductive semiconductor section 12 (Joule heater structure) according to an embodiment.

As exemplarily shown in Fig. 1, the method 100 of operating may comprise a step 110 of providing, during an operational cycle (mode), an activation signal S_{ACT} having a first energy level E₁ (first Joule heating level = provided first energy amount E₁) to the electrically conductive semiconductor section 12 of the thermal emitter 10 for emitting an IR radiation, e.g. a pulsed IR radiation, and further a step 120 of providing, during a refresh cycle (mode), a refresh signal S_{REF} having a second energy level E₂ (second Joule heating level = provided second energy amount E₂) to the electrically conductive semiconductor section 12 of the thermal emitter 10, wherein the second energy level E₂ is different to the first energy level E₁.

The activation signal S_{ACT} may comprise a transient (or pulsed) signal shape, wherein the refresh signal S_{REF} may also comprise a transient (or pulsed) signal shape. In the context of the present description, a transient signal may have a continuous or step-less signal shape between a maximum value and a minimum value, or may have a pulsed signal shape with a rapid (steep) rising edge between a minimum value and maximum value and a rapid (steep) falling edge between a maximum value and a minimum value.

According to embodiments of the present disclosure, an additional refresh cycle for the thermal emitter 10 is introduced into the gas measurement readout routine. The refresh cycle counteracts the electrical resistance drift of the Poly-Si Joule heater 10 occurring from target voltage operation during measurement. The electrical resistance drift may be affected by the temperature-dependent "dopant segregation", wherein the conductivity of poly crystalline silicon is changed (i.e. decreased) by the segregation of dopant atoms to the grain boundaries, where the atoms themselves are trapped and become electrically inactive.

The energy level provided during refresh cycle differs in energy (voltage and time) from an operational measurement such that the resulting drift from the refresh cycle itself counteracts the electrical drift from target voltage operation. By adjusting (optimizing) the energy/Joule-heating (voltage and time and therefore also the conductor temperature) the electrically conductive semiconductor section 12 of the thermal emitter 10 during the refresh cycle, an additional re-arrangement of dopant inside of the semiconductor after a gas measurement or after each gas measurement is triggered to counteract the drift (e.g. up-drift) from target operation. The dopant segregation, which is, for example, responsible for the systematic (up)drift of the electrical resistance of the thermal emitter 10, can be counteracted or reversed by means of the refresh cycle, as the resistivity of the Joule heater structure 12 of the thermal emitter 10 can be maintained on essentially the same value. The refresh cycle(s) can reverse or at least reduce the dopant segregation at the grain boundaries of the poly Si material of the Joule heater structure 12 of the thermal emitter 10.

The temperature dependency of the mechanisms of the dopant-segregation allows for the definition of refresh cycles. Thus, the dopant segregation, which results from the activation signals during the operational cycles, can be effectively counteracted by means of the refresh signal(s) during the operational cycle(s). As consequence, the drift of the electrical resistance of the electrically conductive semiconductor section 12 from a target value can be at least reduced or even avoided.

The refresh cycle concept can be implemented for a thermal heater (essentially) without a hardware adaption, as the same bill of materials (BOM) can be used with an adjusted Firmware on the control unit, e.g. of a PAS CO₂ sensor. Thus, the gas sensor's ppm accuracy is improved over lifetime due to reduced emitter resistance drift.

The thermal emitter 10, e.g. for a gas or fluid sensor, may comprise a relatively high thermal resistance (= low thermal mass) for achieving a relatively high energy efficiency (= high optical output power increase per electrically input power increase = high temperature increase per watt input power) and may be operated with a reduced systematic (up)drift of the electrical characteristic of the thermal emitter for achieving a high PPM accuracy of the gas sensor over lifetime.

According to an embodiment, the energy level E₂ (Joule heating) and, thus, the resulting refresh temperature of the Joule heater structure 12 during the refresh cycle is set to a value for counteracting the dopant segregation in the Joule heater structure 12 (the electrically conductive semiconductor section) of the thermal emitter 10.

According to an embodiment, the energy level of the refresh signal (which is provided during the refresh cycle to the thermal emitter 10) is set to a value which is between 3% and 100% or between 5% and 50% higher than the energy level of the activation signal, which is provided to the Joule heater structure 12 of the thermal emitter 10 during the activation cycle.

Thus, the (pulse) temperature T₂ of the Joule heater structure 12 of the thermal emitter 10 is during the refresh cycle according to the higher energy level E₂ correspondingly higher when compared to the (pulse) temperature T₁ of the Joule heater structure 12 during the activation cycle. Thus, the temperature T₂ of the Joule heater structure 12 during the refresh cycle is set to a value which is, for example, between 3% and 30% higher than the temperature T₁ of the Joule heater structure 12 during the activation cycle (operational cycle). The resulting temperature T₁, T₂ of the Joule heater structure 12 of the thermal emitter depends on the provided energy level E₁, E₂ of the activation signal or the refresh signal.

The temperature difference ΔT (= T₂ - T₁) of the temperature T₂ of the Joule heater structure 12 during the refresh cycle and the temperature T₁ during the activation cycle is set to a value for effectively counteracting the dopant segregation in the Joule heater structure (electrically conductive semiconductor section) 12 of the thermal emitter 10. The adjusted temperature difference ΔT may depend on the geometrical dimensions of the Joule heater structure 12, the used semiconductor material, and the doping material and the doping level of the semiconductor material of the Joule heater structure 12.

The temperature T₂ of the Joule heater structure 12, which is during the refresh cycle for example, between 3% and 30% higher than the temperature T₁ of the Joule heater structure 12 during the activation cycle (operational cycle), may be appropriate for a segregation dominated case where a high temperature is effective to re-diffuse the dopants to become electrically active.

According to a further embodiment, the energy level of the refresh signal (which is provided during the refresh cycle to the thermal emitter 10) is set to a value which is between 3% and 70% or between 5% and 50% lower than the energy level of the activation signal, which is provided to the Joule heater structure 12 of the thermal emitter 10 during the activation cycle.

Thus, the (pulse) temperature T₂ of the Joule heater structure 12 of the thermal emitter 10 is during the refresh cycle according to the lower energy level E₂ correspondingly lower when compared to the (pulse) temperature T₁ of the Joule heater structure 12 during the activation cycle. Thus, the temperature T₂ of the Joule heater structure 12 during the refresh cycle is set to a value which is, for example, between 3% and 30% lower than the temperature T₁ of the Joule heater structure 12 during the activation cycle. The resulting temperature T₁, T₂ of the Joule heater structure 12 of the thermal emitter depends on the provided energy level E₁, E₂ of the activation signal or the refresh signal.

The temperature difference ΔT (= T₁ - T₂) of the temperature T₂ of the Joule heater structure 12 during the refresh cycle and the temperature T₁ during the activation cycle is set to a value for effectively counteracting the dopant segregation in the Joule heater structure (electrically conductive semiconductor section) 12 of the thermal emitter 10. The adjusted temperature difference ΔT may depend on the geometrical dimensions of the Joule heater structure 12, the used semiconductor material, and the doping material and the doping level of the semiconductor material of the Joule heater structure 12.

The temperature T₂ of the Joule heater structure 12, which is during the refresh cycle for example, between 3% and 30% lower than the temperature T₁ of the Joule heater structure 12 during the activation cycle, may be appropriate in a case where the operation over-drives the dopants resulting an over-diffuse case. In such cases a lower temperature T₂, i.e. lower refresh voltage, would be effective to counteract the over-diffusion.

According to an embodiment, the refresh signal may have a transient or pulsed signal shape (course), wherein the activation signal may have a transient or pulsed signal shape (course) for achieving a pulsed emission of IR radiation of the thermal emitter 10.

According to an embodiment, the energy level E₁ of the activation signal may be adjusted by setting at least one (or two or all) of a signal strength (activation voltage V₁), an activation length (or pulse length) and a number of activated states (or a number of pulses) of the activation signal. Further, the energy level E₂ of the refresh signal may be adjusted by setting at least one (or two or all) of a signal strength (refresh voltage V₂), an activation length (or a pulse length) and a number of activated states (or a number of pulses) of the refresh signal.

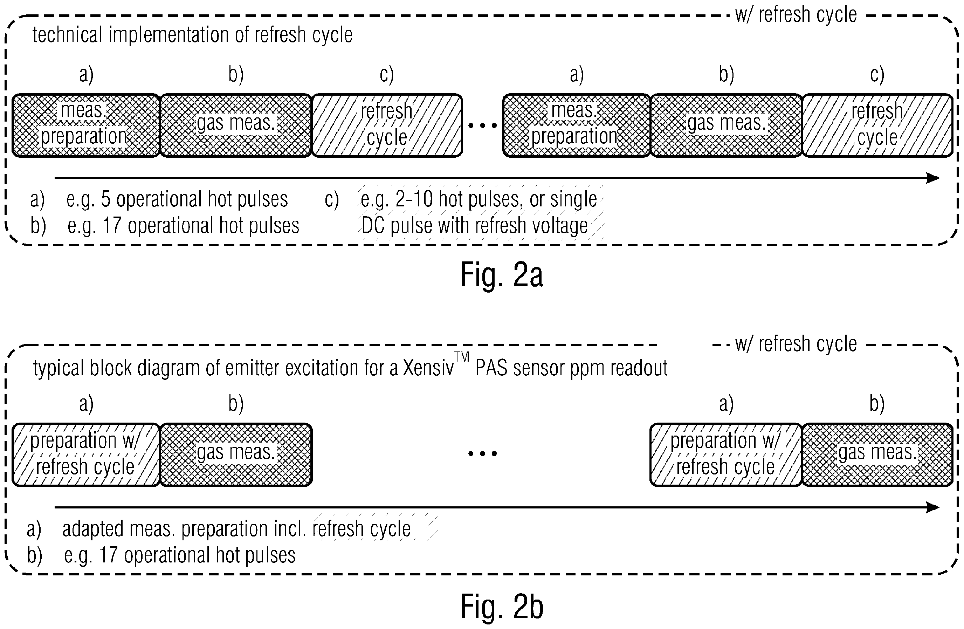

Figures 2a-b show schematic block diagrams of a thermal emitter excitation with a refresh cycle according to an embodiment.

As exemplarily shown in Fig. 2a, the refresh cycle may be performed after each, after each second, after each third, ..., operational cycle (e.g. gas measurement). Thus, the refresh cycle may be conducted (intermittently or periodically) between two operational cycles or may be conducted each time between two operational cycles of the thermal emitter.

As exemplarily shown in Fig. 2a, an operational cycle may be divided in a preparation mode (e.g. a measurement preparation of a sensor) and an activation mode (e.g. a gas measurement of the sensor), wherein the refresh cycle is conducted after the operational cycle (having the preparation mode and the activation mode). The preparation mode (measurement preparation) may comprise, for example, two to eight or five operational "hot" pulses, wherein the activation mode (gas measurement) may comprise ten to twenty-five or seventeen operational hot pulses with the activation voltage V₁.

The refresh cycle may comprise a plurality of hot pulses (activation pulses) or a single DC pulse with the refresh voltage V₂. The refresh cycle may comprise, for example, one to hundred or one to twenty hot pulses or may comprise two to twenty-five or two to ten hot pulses (activation pulses) with the refresh voltage V₂. As outlined above, the provided energy level of the refresh cycle is between 3% and 100% or between 5% and 50% higher or between 3% and 70% or between 5% and 50% lower than the provided energy level E₁ of the activation signal during the operational cycle.

As exemplarily shown in Fig. 2b, the refresh cycle may be included into the preparation routine of the thermal emitter 10 (e.g. the measurement preparation routine of a sensor). Thus, the refresh cycle may be conducted (intermittently or periodically) before or each time before an operational cycle of the thermal emitter 10.

The adapted preparation mode (adapted measurement preparation) may comprise, for example, two to eight or five operational "hot" pulses with the activation voltage V₁ and, additionally or alternatively, the refresh cycle with one to twenty or two to ten hot pulses or a single DC pulse with the refresh voltage V₂, wherein the activation mode (gas measurement) may comprise ten to twenty-five or seventeen operational hot pulses with the activation voltage V₁. As outlined above, the provided energy level of the refresh cycle is between 3% and 100% or between 5% and 50% higher or between 3% and 70% or between 5% and 50% lower than the provided energy level E₁ of the activation signal during the operational cycle.

Thus, according to an embodiment, the activation signal may comprise a plurality of DC activation pulses, wherein the refresh signal may comprise at least one or a plurality of DC refresh pulses.

Embodiments of the present concept describe an improvement of thermal emitters 10, e.g., for the use with gas sensors, wherein the thermal emitter 10 comprises a Joule heater structure 12 (an electrically conductive semiconductor section), e.g. comprising a poly-Si or SiC material. Based on the described method for operating such a thermal emitter 10, the drift (resistance drift) over a lifetime due to the thermal non-uniformity on the heater structure under operational conditions can be reduced or even avoided. According to embodiments, the additional refresh cycle may be included into each operational cycle, e.g. into each operational gas measurement block. The electrical parameters, such as the signal strength (activation voltage V₁), the activation length (pulse length) and the number of activated states (number of pulses), of the refresh cycle are chosen such that the observed drift under operational conditions is counteracted by the drift induced from the refresh cycle itself. The refresh cycle can be DC pulse at a refresh voltage or a block of multiple pulsed (AC) excitations.

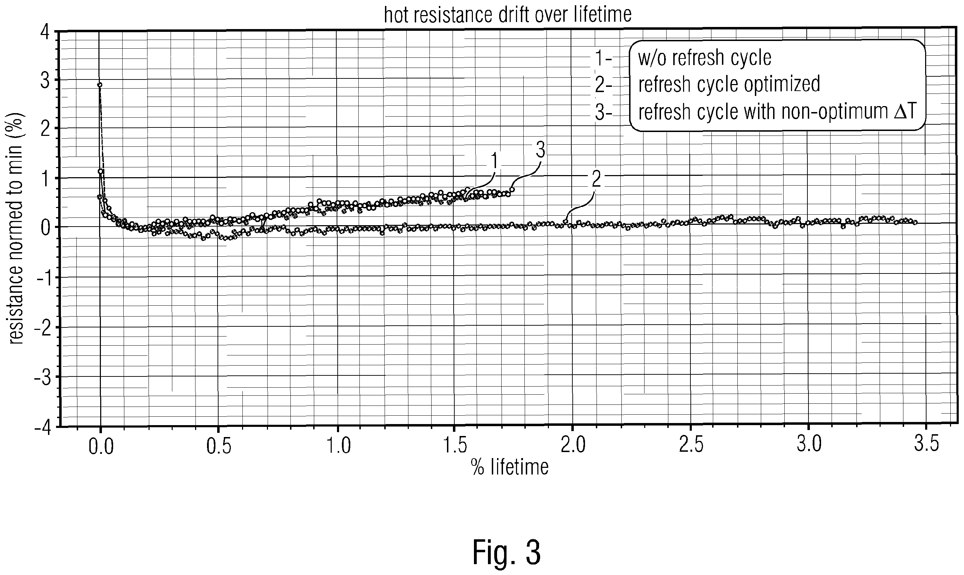

Fig. 3 shows a schematic illustration of the "hot" drift behavior of a thermal emitter over lifetime with a refresh operation when compared to a thermal emitter operation without refresh operation. The PPM accuracy measurements with refresh cycling may be done by firmware adaptations, e.g. on PAS CO₂ sensors.

Curves 1 and 3 of Fig. 3 exemplarily show the observed electrical drift without a refresh cycling or with a not optimized energy level (resulting in a non-optimum ΔT) of the refresh cycle on a PAS system level, resulting in an up-drift of the resistance with causes resistance drifts of the Joule heater structure 12 and, thus, a drift of the PPM accuracy of a gas sensor in the range of the typical target spec corridor. Curve 2 shows the resistance of a Joule heater structure 12 of a thermal emitter with an "optimized" refresh cycling with an essentially reduced resistance drift of the Joule heater structure 12 and, thus, a reduced drift of the PPM accuracy of a gas sensor over lifetime.

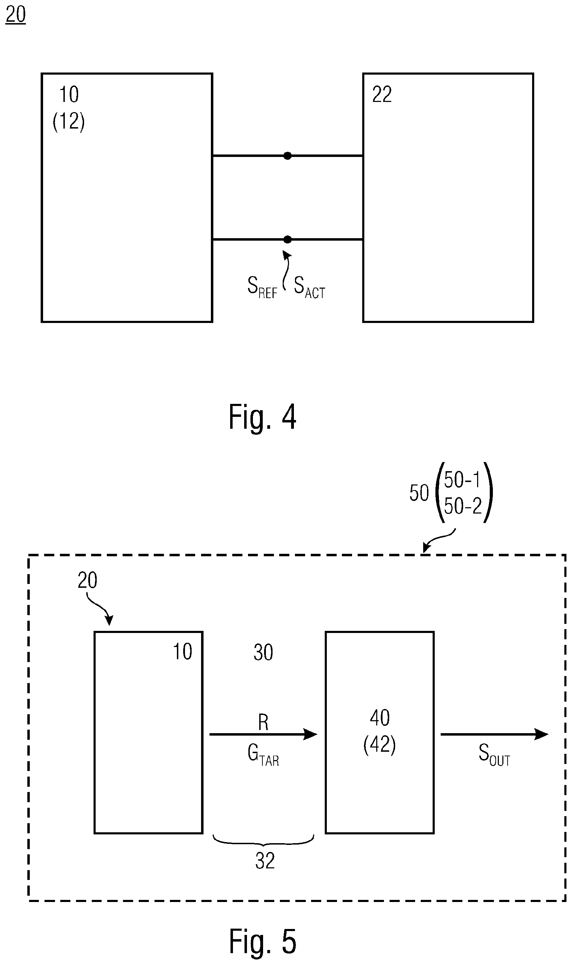

Fig. 4 shows a schematic block diagram of a thermal emitter device 20 according to an embodiment. The thermal emitter device 20 comprises a thermal emitter 10 having a Joule heater structure 12 (an electrically conductive semiconductor section), and a driver element 22, e.g. an ASIC or a microcontroller, for providing, during an operational cycle, an activation signal S_{ACT} having a first energy level E₁ to the electrically conductive semiconductor section 12 of the thermal emitter 10 for emitting an IR radiation R, and providing, during a refresh cycle, a refresh signal S_{REF} having a second energy level E₂ to the electrically conductive semiconductor section 12 of the thermal emitter, wherein the second energy level E₂ is different to the first energy level E₁.

According to an embodiment, the driver element 22 is arranged for providing the activation signal S_{ACT} and the refresh signal S_{REF} to the heater element 10 for conducting the method steps of the method 100 for operating the thermal emitter 10 as exemplarily described with respect to Figs. 1 to 3. According to an embodiment, the electrically conductive semiconductor section 12 may form a branched current path separated by a center section 12-1 of the thermal emitter 10.

According to an embodiment, the electrically conductive semiconductor section 12 of the thermal emitter 10 may be arranged on a cavity 18 in a substrate 14 to which the heater element is attached. According to an embodiment, the electrically conductive semiconductor section 12 of the thermal emitter 10 may comprise a poly-Si or SiC material.

Fig. 5 shows a schematic block diagram of a fluid sensor 50 (50-1, 50-2) using the thermal emitter 10 (Joule heater-MEMS heater) according to an embodiment, e.g. according to Fig. 4. According to an embodiment, the MEMS gas or fluid sensor 50 comprises the thermal emitter 10 for emitting thermal radiation R as described with respect to Figs. 1-4 and 8-9, a measurement volume 30 having a target gas G_{TAR} or target fluid F_{TAR} and providing an optical interaction path 32 for the emitted thermal radiation R, and an acoustic transducer 40 or a direct thermal detector 42 for providing a detector output signal S_{OUT} based on the optical interaction of the emitted thermal radiation R with the target gas or target fluid in the measurement volume 30.

According to an embodiment, the fluid sensor may be formed as a PAS (photoacoustic system) gas detector (fluid detector) 50-1, wherein the thermal emitter device 20 comprises a heater element 10 (Joule heater) having an electrically conductive semiconductor section 12, and a drive element 22 (e.g. an ASIC or a microcontroller) for conducting the method 100. According to a further embodiment, the fluid sensor 50 may be formed as a NDIR (NDIR = non-dispersive infra-red) gas detector 50-2, wherein the thermal emitter device 20 comprises a (heater) element (Joule heater) 10 having an electrically conductive semiconductor section 12 and a drive element 22 (e.g. an ASIC or a microcontroller) for conducting the method 100.

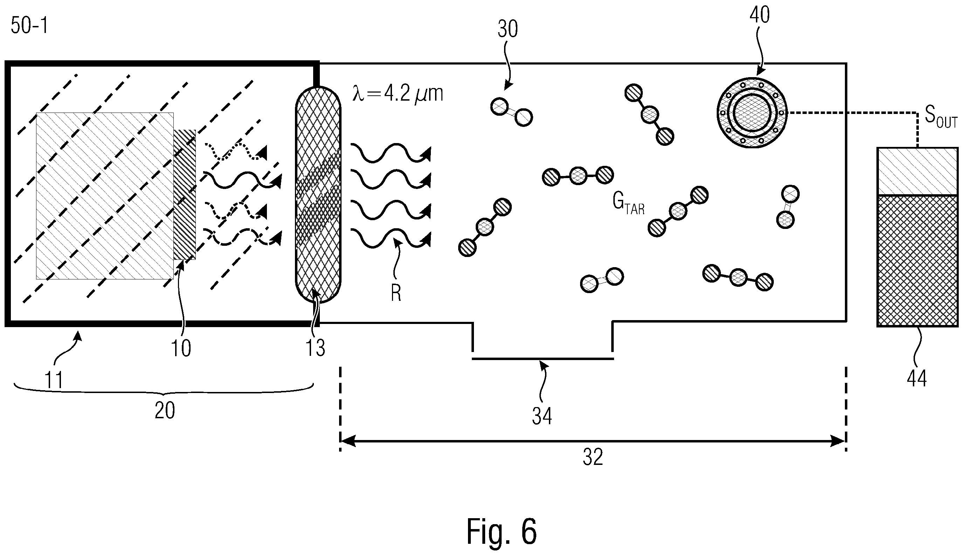

Fig.6 shows a schematic block diagram of a fluid (gas or liquid) sensing device 50-1 in the form of a PAS gas sensor according to a further embodiment. As shown in Fig. 6, the PAS gas sensor 50-1 comprises the thermal emitter 10 which is arranged in a package 11, e.g. an acoustically tight package. The package 11 may provide an acoustically tight chamber (absorption chamber) isolated from external noise. Thus, the package 11 may form a closed mid-IR emitter package for emitting the (filtered) radiation R into the measurement volume. The thermal emitter device 20 comprises the (heater) element 10 having the electrically conductive semiconductor section 12. The heater element 10 may be actuated by the actuation signal S_{ACT}, e.g. the heater element 10 may be periodically chopped. The package 11 may comprise an optical filter 13 for a wavelength selection of the emitted radiation R.

The gas sensor device 50-1 further comprises the sample area (interaction area) 30, where the light or a radiation R between the light source (heater element) 10 and the detector 40 interacts with the environmental medium. The optical filter 13 is arranged to filter the wavelength related to a specific gas, e.g. a wavelength λ = 4.26 µm for CO₂. The detector 40 may be formed, for example, as a (capacitive or piezoelectric) MEMS microphone. In the interaction area 30, the molecules of the target gas G_{TAR} (e.g. CO₂ molecules) absorb the light R emitted from the heater element 10 and filtered by the optical filter 13. The light absorption causes a periodic local change of temperature in the interaction area 30, which results in corresponding pressure changes in the interaction area 30. The periodic pressure changes are detected by the acoustic detector 40, e.g. a MEMS microphone, which may be optimized for low frequency operation. The acoustic detector 40 may be read-out by means of an ASIC 42, for example, moreover, the closed interaction area may be accessible through a fluid port 34 for a fluid (gas or liquid) diffusion.

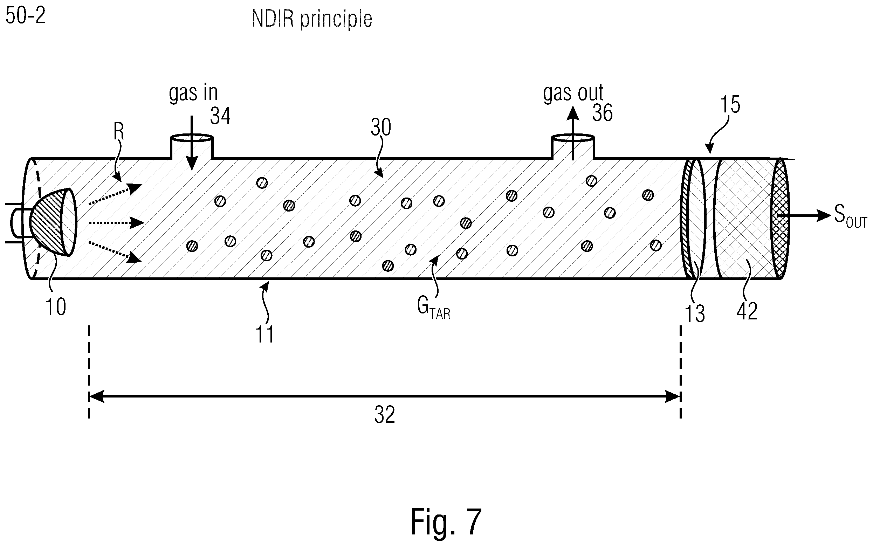

Fig. 7 shows a schematic block diagram of a fluid (gas or liquid) sensing device in the form of an NDIR gas sensor 50-2 having the thermal emitter 10 according to a further embodiment. According to Fig. 7, the NDIR sensor device 50-2 comprises the thermal emitter 10, a sample chamber or light tube 11, and a closed package 15 for the detector 42. The package 15 may comprise a filter element 13 for a wavelength selection and the sample area (interaction area) 30 which is accessible by means of a gas inlet 34 and gas outlet 36. In the interaction area 30 (for providing the interaction path 32), the light R between the light source (thermal emitter) detector interacts with the environmental medium, e.g. the target gas G_{TAR}.

Thus, the main components of the NDIR sensor 50-2 are the thermal emitter 10, the sample chamber or light tube 11, the light filter 13 and the infrared detector 42 in the package 15. The IR light (radiation) R is directed through the sample chamber 11 towards the packaged detector 42. The target gas in the sample chamber 11 causes an absorption of a specific wavelength and the intensity change at this wavelength is measured by the detector 42 to determine/derive the target gas concentration. The optical filter 13 (optically) in front of the detector 42 is arranged to eliminate all light except the wavelength that the target gas molecules can absorb.

By using the method 100 as shown in Fig. 1 for operating a thermal emitter 10 (MEMS heater) having an electrically conductive semiconductor section 12 (Joule heater structure) an effective drift stabilization of the PAS system or NDIR system can be achieved.

In physical gas sensors, such as photo-acoustic spectroscopy (PAS) and non-dispersive infrared (NDIR) sensors, the improved operational characteristics (the improved drift behavior) of the emitter 10 used as a sub-component of these systems also improves the long term drift stability of these gas sensor systems. As the emitter unit is operated by voltage control, the electrically stable emitter unit 100 achieves a stable ppm reading of the gas sensor. Thus, the emitter 10 having an improved electrical stability will improve the system performance. This is especially true for gas sensor systems with even lower-ohmic Poly-Si MEMS Heaters to enable a low, e.g. a 3V, voltage domain.

Additional embodiments and aspects are described which may be used alone or in combination with the features and functionalities described herein.

According to an embodiment, a method for operating a thermal emitter having an electrically conductive semiconductor section, comprises providing, during an operational cycle, an activation signal having a first energy level (Joule heating level) to the electrically conductive semiconductor section of the thermal emitter for emitting an IR radiation, and providing, during a refresh cycle, a refresh signal having a second energy level to the electrically conductive semiconductor section of the thermal emitter, wherein the second energy level is different to the first energy level.

According to an embodiment, the second energy level of the refresh cycle is set to a value for counteracting a dopant segregation in the electrically conductive semiconductor section of the thermal emitter.

According to an embodiment, the energy level of the refresh signal is set to a value which is between 3% and 100% higher than the energy level of the activation signal, or wherein the energy level of the refresh signal is set to a value which is between 3% and 70% lower than the energy level of the activation signal.

According to an embodiment, a temperature T₂ of the Joule heater structure during the refresh cycle is set to a value which is between 3% and 30% higher than a temperature T₁ of the Joule heater structure during the operational cycle, or wherein a temperature T₂ of the Joule heater structure during the refresh cycle is set to a value which is between 3% and 30% lower than a temperature T₁ of the Joule heater structure during the operational cycle.

According to an embodiment, the refresh signal has a transient (or pulsed) signal shape, and wherein the activation signal has a transient (or pulsed) signal shape.

According to an embodiment, the method further comprises setting the first energy level by setting at least one of a signal strength, an activation length (or pulse length) and a number of activated states (or pulses) of the activation signal, and setting the second energy level by setting at least one of a signal strength, an activation length (or pulse length) and a number of activation states (or pulses) of the refresh signal.

According to an embodiment, the method further comprises conducting the refresh cycle between two operational cycles.

According to an embodiment, the method further comprises conducting the refresh cycle each time between two operational cycles.

According to an embodiment, the method further comprises conducting the refresh cycle before or each time before an operational cycle of the thermal emitter.

According to an embodiment, the activation signal comprises a plurality of DC activation pulses, and wherein the refresh signal comprises at least one DC refresh pulse,

According to an embodiment, a thermal emitter device comprises a thermal emitter having an electrically conductive semiconductor section, and a driver element (e.g. an ASIC or a microcontroller) for providing, during an operational cycle, an activation signal having a first energy level to the electrically conductive semiconductor section of the thermal emitter for emitting an IR radiation, and providing, during a refresh cycle, a refresh signal having a second energy level to the electrically conductive semiconductor section of the thermal emitter, wherein the second energy level is different to the first energy level.

According to an embodiment, the driver element is arranged for providing the activation signal and the refresh signal to the thermal emitter for conducting the method steps of the method for operating a thermal emitter.

According to an embodiment, the electrically conductive semiconductor section forms a branched current path separated by a center section of the thermal emitter.

According to an embodiment, the electrically conductive semiconductor section of the thermal emitter is arranged on a cavity in a substrate to which the thermal emitter is attached.

According to an embodiment, the electrically conductive semiconductor section of the thermal emitter comprises a poly-Si or SiC material.

According to an embodiment, a MEMS gas or fluid sensor comprises a thermal emitter for emitting thermal radiation, a measurement volume having a target gas or target fluid and providing an optical interaction path for the emitted thermal radiation, and an acoustic transducer or a direct thermal detector for providing a detector output signal based on the optical interaction of the emitted thermal radiation with the target gas or target fluid in the measurement volume.

Although some aspects have been described as features in the context of an apparatus it is clear that such a description may also be regarded as a description of corresponding features of a method. Although some aspects have been described as features in the context of a method, it is clear that such a description may also be regarded as a description of corresponding features concerning the functionality of an apparatus.

In the foregoing detailed Description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus the following claims are hereby incorporated into the Detailed Description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

## Claims

1. Method (100) for operating a thermal emitter (10) having an electrically conductive semiconductor section (12), comprising:
providing (110), during an operational cycle, an activation signal (S_{ACT}) having a first energy level (E₁) to the electrically conductive semiconductor section (12) of the thermal emitter (10) for emitting an IR radiation (R), and
providing (120), during a refresh cycle, a refresh signal (S_{REF}) having a second energy level (E₂) to the electrically conductive semiconductor section (12) of the thermal emitter (10), wherein the second energy level (E₂) is different to the first energy level (E₁).

2. The method (100) of claim 1, wherein the second energy level (E₂) of the refresh cycle is set to a value for counteracting a dopant segregation in the electrically conductive semiconductor section (12) of the thermal emitter (10).

3. The method of claim 1 or 2,
wherein the energy level (E₂) of the refresh signal (S_{REF}) is set to a value which is between 3% and 100% higher than the energy level (E₁) of the activation signal (S_{ACT}),
or
wherein the energy level (E₂) of the refresh signal (S_{REF}) is set to a value which is between 3% and 70% lower than the energy level (E₁) of the activation signal (S_{ACT}).

4. The method (100) of any of the preceding claims,
wherein a temperature T₂ of the Joule heater structure (12) during the refresh cycle is set to a value which is between 3% and 30% higher than a temperature T₁ of the Joule heater structure (12) during the operational cycle,
or
wherein a temperature T₂ of the Joule heater structure (12) during the refresh cycle is set to a value which is between 3% and 30% lower than a temperature T₁ of the Joule heater structure (12) during the operational cycle,

5. The method (100) of any of the preceding claims, wherein the refresh signal has a transient (or pulsed) signal shape, and wherein the activation signal has a transient (or pulsed) signal shape.

6. The method (100) of any of the preceding claims, further comprising:
setting the first energy level (E₁) by setting at least one of a signal strength, an activation length (or pulse length) and a number of activated states (or pulses) of the activation signal, and
setting the second energy level (E₂) by setting at least one of a signal strength, an activation length (or pulse length) and a number of activation states (or pulses) of the refresh signal.

7. The method (100) of any of the preceding claims, further comprising:
conducting the refresh cycle between two operational cycles or each time between two operational cycles.

8. The method (100) of any of the preceding claims, further comprising:
Conducting the refresh cycle before or each time before an operational cycle of the thermal emitter (10).

9. The method (100) of any of the preceding claims, wherein the activation signal (S_{ACT}) comprises a plurality of DC activation pulses, and wherein the refresh signal (S_{REF}) comprises at least one DC refresh pulse,

10. A thermal emitter device (20) comprising:
a thermal emitter (10) having an electrically conductive semiconductor section (12), and
a driver element (22) for
providing (110), during an operational cycle, an activation signal (S_{ACT}) having a first energy level (E₁) to the electrically conductive semiconductor section (12) of the thermal emitter (10) for emitting an IR radiation (R), and
providing (120), during a refresh cycle, a refresh signal (S_{REF}) having a second energy level (E₁) to the electrically conductive semiconductor section (12) of the thermal emitter (10), wherein the second energy level (E₂) is different to the first energy level (E₁).

11. The thermal emitter device (20) of claim 10, wherein the driver element (22) is arranged for providing the activation signal and the refresh signal to the thermal emitter for conducting the method steps of the method (100) of claims 1 to 9.

12. The thermal emitter device (20) of claim 10 or 11, wherein the electrically conductive semiconductor section (12) forms a branched current path separated by a center section (12-1) of the thermal emitter (10).

13. The thermal emitter device (20) of any of claims 10 to 12, wherein the electrically conductive semiconductor section (12) of the thermal emitter (10) is arranged on a cavity (18) in a substrate (16) to which the thermal emitter (10) is attached.

14. The thermal emitter device (20) of any of claims 11 to 13, wherein the electrically conductive semiconductor section (12) of the thermal emitter (10) comprises a poly-Si or SiC material.

15. A MEMS gas or fluid sensor (50; 50-1; 50-2), comprising:
a thermal emitter device (20) for emitting thermal radiation according to any of claims 10 to 14,
a measurement volume (30) having a target gas or target fluid and providing an optical interaction path (32) for the emitted thermal radiation (R), and
an acoustic transducer (40) or a direct thermal detector (42) for providing a detector output signal (S_{OUT}) based on the optical interaction of the emitted thermal radiation (R) with the target gas or target fluid in the measurement volume (30).
